# EUROPEAN PATENT SPECIFICATION

(11) **EP 1 693 703 B1**
(45) Date of publication and mention of the grant of the patent: **26.03.2014**
(21) Application number: 04818568.0
(22) Date of filing: 15.11.2004
(51) Int. Cl.: G03F 7/004, G03F 7/38, G03F 7/40, B32B 3/00, G02B 1/02

(54) **METHOD OF FIXING ORGANIC MOLECULE AND MICRO/NANO-ARTICLE**
VERFAHREN ZUM FIXIEREN EINES ORGANISCHEN MOLEKÜLS UND EINES MIKRO-/NANOARTIKELS
PROCEDE DE FIXATION DE MOLECULE ORGANIQUE ET MICRO/NANOARTICLE

(30) Priority: 15.11.2003 JP 2003420115
(43) Date of publication of application: 23.08.2006
(73) Proprietor: National Institute for Materials Science, Tsukuba-shi, Ibaraki 305-0047 (JP)
(72) Inventor: OISHI, Tetsuo, Tsukuba-shi, Ibaraki 305-0047 (JP); GOTO, Masahiro, Tsukuba-shi, Ibaraki 305-0047 (JP); KASAHARA, Akira, Tsukuba-shi, Ibaraki 305-0047 (JP); TOSA, Masahiro, Tsukuba-shi, Ibaraki3 05-0047 (JP); YOSHIHARA, Kazuhiro, Tsukuba-shi, Ibaraki 305-0047 (JP)
(74) Representative: Calamita, Roberto
(86) International application number: PCT/JP2004/017313
(87) International publication number: WO 2005/047977

(56) References cited:
- EP-A1- 0 652 489
- EP-A2- 1 475 230
- JP-A- 8 022 116
- JP-A- 2002 083 688
- JP-A- 2002 363 209
- US-A- 4 452 879
- US-A- 4 911 733
- US-A1- 2002 045 112
- US-B1- 6 335 531

## Description

### Technical Field

The invention of this application relates to a method of fixing an organic molecule for the purposes of disposing and arranging an organic molecule in a fine region on the surface of a substrate in a given pattern. In more detail, the invention relates to a method of fixing an organic molecule, which is useful for preparing functional micro/nano articles such as optical materials such as photonic crystals and optical devices, and to a micro/fine article as prepared therefrom.

### Background Art

In preparing micro/nano-scale materials Including photonic crystals and devices, semi-conductor processes represented by photolithography have hitherto been applied (see, for example, Non-Patent Document 1). However, with respect to these processes, the process is a multi-stage process and is very complicated, devices to be used are expensive, and useful raw materials are extremely limited to, for example, silicon. Therefore, these processes were poor in functionality and were lacking in appeal as a material. Also, in these materials, it was impossible to control characteristics by an external field, for example, optical characteristics by an electric field or a magnetic field so that their applications to devices were limited.

EP-A-1 475 230 describes the use of a polymer layer on a PET support. In Example 7 a photo-patterned material Is immersed in an aqueous dispersion of TiO₂ fine particles. US-A-2002/0045112 relates to colour resists having three colours and including photo initiators. US-B-6335531 describes a process for modifying a resist either prior to patterning or thereafter, in which a fluorescent material is added to the resist.
Non-Patent Document 1

"Photonic-bandgap microcavities in optical waveguides", J.S. Foresi, P.R. Villeneuve, et al., Nature, Vol. 390, p.143, 1997

Then, problems of the invention of this application are to overcome the foregoing points at issue of the related art and to provide a new technical measure capable of preparing various functional micro/nano materials including photonic crystals and articles thereof simply and easily and inexpensively utilizing various functional organic molecules and having a large degree of freedom in selection of materials and in selection of shapes or patterns.

### Disclosure of the Invention

For the sake of solving the foregoing problems, a first aspect of the invention of this application is to provide a method of fixing an organic molecule, which is characterized by irradiating a photocurable resin containing an organic molecule on a substrate with light, thereby curing the photocurable resin in a given pattern and removing an uncured portion, thereby fixing the organic molecule in the given pattern on the substrate, wherein said organic molecule is selected from the group consisting of coumarin 6, coumarin 545, ZnTPP, anthracene, dicyanoanthracene, Nile Red. Fluoresceine and pyrene.

Then, with respect to this method, a second aspect is to provide a method of fixing an organic molecule, which is characterized in that condensed light is irradiated in a given pattern, thereby curing the photocurable resin in the given pattern; a third aspect is to provide a method of fixing an organic molecule, which is characterized in that laser light is irradiated, thereby curing the photocurable resin in the given pattern; a fourth aspect is to provide a method of fixing an organic molecule, which is characterized in that light is irradiated using a mask pattern, thereby curing the photocurable resin in the given pattern; and a fifth aspect is to provide a method of fixing an organic molecule, which is characterized in that an organic molecule capable of absorbing light having a specific wavelength is contained and that light having a wavelength which the contained organic molecule absorbs is irradiated, thereby curing the photocurable resin.

Also, a sixth aspect of the invention of this application is to provide a method of fixing an organic molecule, which is characterized by curing a photocurable resin in a given pattern on a substrate by irradiation with light and subsequently bringing it into contact with a solution containing an organic molecule, thereby penetrating the organic molecule into the photocurable resin, wherein said organic molecule is selected from the group consisting of coumarin 6, coumarin 545, ZnTPP, anthracene, dicyanoanthracene, Nile Red, Fluoresceine and pyrene; and a seventh aspect is to provide a method of fixing an organic molecule, which is characterized in that the organic molecule is penetrated by Immersing in the solution of an organic molecule.

Then, with respect to these methods, an eighth aspect is to provide a method of fixing an organic molecule, which is characterized in that condensed light is irradiated in a given pattern, thereby curing the photocurable resin in the given pattern; a ninth aspect is to provide a method of fixing an organic molecule, which is characterized in that laser light is irradiated, thereby curing the photocurable resin in the given pattern; and a tenth aspect is to provide a method of fixing an organic molecule, which is characterized in that light is irradiated using a mask pattern, thereby curing the photocurable resin in the given pattern.

In addition, an eleventh aspect of the invention of this application is to provide a method of fixing an organic molecule of any one of the foregoing methods, which is characterized in that the cured shape of the photocurable resin is controlled by the beam shape of condensed light; a twelfth aspect is to provide a method of fixing an organic molecule, which is characterized by repeating any one of the foregoing methods or combining them, thereby fixing each of plural kinds of organic molecules in an individual cured part of the photocurable resin; and a thirteenth aspect is to provide a method of fixing an organic molecule, which is characterized in that the organic molecule is a molecule having at least one functionality of photo, magnetic and electronic functions.

Also, a fourteenth aspect of the invention of this application is to provide a micro/nano article, which is characterized by being prepared by any one of the foregoing methods.

By applying to the preparation of micro/nano parts, it is possible to control refractive index, magnetism, dielectric constant, conductivity, and so on in a high degree of freedom, thereby bring various functionalities. Thus, applications in an extensive field including optical and nano technologies, especially applications as photonic crystals can be expected, and marked improvements in optical, magnetic and electric characteristics and so on can be expected. Also, the process is simple and low in costs as compared with semi-conductor processes of the related art. Accordingly, its effects are extremely large such that the manufacturing time and costs can be largely reduced.

Furthermore, concretely, for example, it is possible to fix various functional organic molecules in an arbitrary configuration or arrangement by a simple process of condensing or irradiating laser light. Also, it is possible to change its size from nanometers to millimeters by selecting a laser light source. In addition, since it is possible to dispose plural organic molecules on the same substrate by repeating or combining the processes, its technical effects are large.

### Brief Description of the Drawings

Fig. 1 is a flow diagram to exemplify the method of the invention of this application.
Fig. 2 is a fluorescent microscopic photograph of a dot pattern of Example 1.
Fig. 3 is a fluorescent microscopic photograph of Example 2.
Fig. 4 is a fluorescent microscopic photograph of a dot pattern of Example 3.
Fig. 5 is an SEM image of a dot pattern of Example 3.
Fig. 6(1) is an optical photograph of a dot pattern prior to the penetration of an organic molecule in Example 4; and Fig. 6(2) is a fluorescent microscopic photograph of a dot pattern after the penetration of an organic molecule in Example 4.

### Best Mode for Carrying Out the Invention

Embodiments of the invention of this application having the foregoing characteristic features will be hereunder described.

As described previously, the invention of this application is characterized by irradiating a photocurable resin containing an organic molecule with light, thereby curing the photocurable resin in a given pattern and removing an uncured portion, thereby fixing the organic molecule in the given pattern on a substrate. A wavelength of the light to be irradiated is selected depending upon the kind of a photocurable resin and its properties and reactivity. All of visible light having a wavelength of from 390 to 820 nm and ultraviolet light having a wavelength of not longer than 390 nm are employable. Furthermore, the light source may be a light source for irradiating laser light or may be a fluorescent lamp, a mercury vapor lamp, or a halogen lamp.

More preferably, what light which has been condensed to extent of a region closed to a wavelength diffraction limit is irradiated in a given pattern to cure the photocurable resin in the given pattern, especially visible or ultraviolet laser light is irradiated to cure the photocurable resin in the given pattern is taken into consideration as a preferred embodiment. Alternatively, in the invention of this application, the photocurable resin may be cured in a given pattern by irradiation with light using a mask pattern.

With respect to the kind of the photocurable resin which is cured by irradiation with light, various kinds such as acrylic resin bases and methacrylic resin bases may be employed, and the photocurable resin does not react with the organic molecule to be contained. Such a photocurable resin is disposed as a material containing an organic molecule on a substrate. On this occasion, there are properly employed measures for coating, spraying or dropwise addition in a given pattern of a solution of the photocurable resin containing an organic molecule in an organic solvent such as ethers, THF, ketones, esters, DMSO, nitriles, DMF, and toluene on the surface of a substrate.

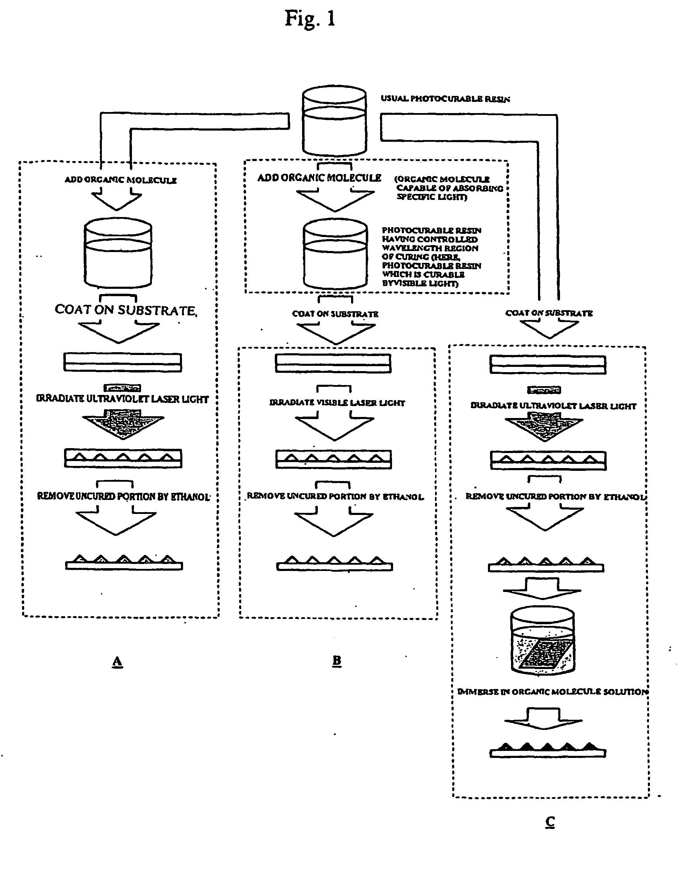

For example, as illustrated in Method (A) of Fig. 1, as one configuration, an organic molecule is added and mixed in a solution of a usual photocurable resin, and this solution is coated on a substrate. After coating, for example, ultraviolet laser light is irradiated in a given pattern, and an uncured portion is removed by ethanol to obtain a dot arrangement of the photocurable resin as cured in the given pattern. The removal of the uncured portion can be easily realized by dissolution and removal by an organic solvent of every kind. As a matter of course, the removal may be achieved using a gas.

In any event, in that case, the organic molecule is fixed to each dot. The dot shape and size can be controlled by the beam shape of the laser light. The dot size can be selected within the range of from nanometers to millimeters.

Furthermore, in such a method, as in Method (B) of Fig. 1, the photocurable resin may be cured by containing an organic molecule capable of absorbing light having a specific wavelength and irradiating light having a wavelength which the contained organic molecule absorbs. In that case, even when the photocurable resin is a photocurable resin which is curable by ultraviolet light, the photocurable resin can be cured even by visible light through light absorption of the organic molecule.

Moreover, the invention of this application also provides a method of fixing an organic molecule, which is characterized by curing a photocurable resin in a given pattern on a substrate by irradiation with light and subsequently bringing it into contact with a solution containing an organic molecule, thereby penetrating the organic molecule into the photocurable resin.

The contact of the cured resin with the organic molecule-containing solution can be carried out by various measures, for example, spraying, flowing down or coating of the organic molecule-containing solution. More simply and easily, as exemplified as Method (C) of Fig. 1, there is taken into consideration a method of immersing the cured resin in a solution of an organic molecule, thereby penetrating the organic molecule thereinto.

With respect to the curing of the photocurable resin prior to the penetration of the organic molecule, likewise the foregoing case, there is taken into consideration a method of irradiating condensed light in a given pattern, thereby curing the photocurable resin in the given pattern, especially preferably a method of irradiating laser light, thereby curing the photocurable resin in the given pattern.

As a matter of course, a method of irradiating light using a mask pattern, thereby curing the photocurable resin in the given pattern may also be employed.

In the light of the above, in the invention of this application, for example, it is also possible to fix each of plural kinds of organic molecules In an individual cured part of the photocurable resin or fix them in the same cured part by repeating or combining the respective measures of Methods (A), (B) and (C) of Fig. 1.

The organic molecule can be preferably selected among organic molecules having various functions, for example, an optical function, a magnetic function, or an electron function. The organic molecule is chosen from the group consisting of coumarin 6, coumarin 545, ZnTPP, anthracene, dicyanoanthracene, Nile Red, Fluoresceine, and pyrene. Similarly, various materials are employable with respect to the substrate. Examples thereof include resins, glasses, ceramics, metals, and mixtures of two or more kinds thereof.

Then, the invention will be hereunder described in more detail with reference to the following Examples. As a matter of course, the invention is never limited to these Examples. Incidentally, in the following Example, an ultraviolet light curable resin (SCR701) as manufactured by D-MEC is used. Furthermore, with respect to the kind of the organic molecule, coumarin, dicyanoanthracene and zinc tetraphenylporphyrin were used. These organic molecules which were used are all commercially available. At the time of containing the organic molecule in the photocurable resin, any one of these organic molecules was directly added and mixed in the photocurable resin. The irradiation is carried out using a pulse light source, and in preparing a single dot, a pulse is irradiated once or plural times. Energy per pulse was set up at about 300 J/cm² in the case of ultraviolet laser light and about 6 mJ/cm² in the case of visible laser light, respectively.

### Examples

### <Example 1>

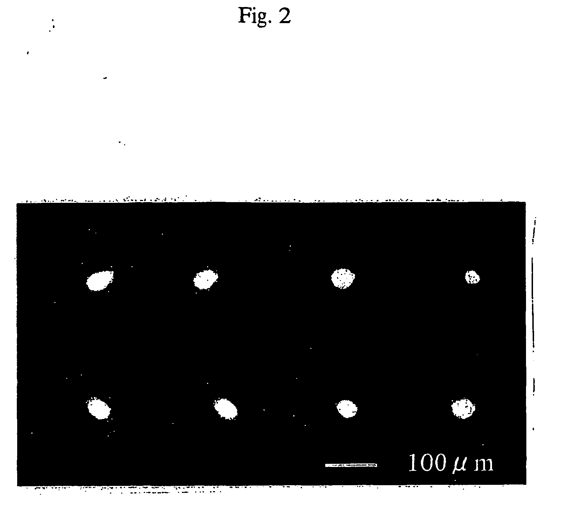

According to Method (A) of Fig. 1, condensed ultraviolet laser light was irradiated on a photocurable resin containing coated dicyanoanthracene as an organic molecule, thereby curing only a desired portion, and thereafter, an uncured portion was removed by ethanol. A fluorescent microscopic photograph of the prepared dot pattern is shown in Fig. 2. Dot size and interval were 50 µm and 160 µm, respectively. In other molecules, it was confirmed that such a dot pattern can be prepared in the same manner and can be prepared in an arbitrary configuration or arrangement.

### <Example 2>

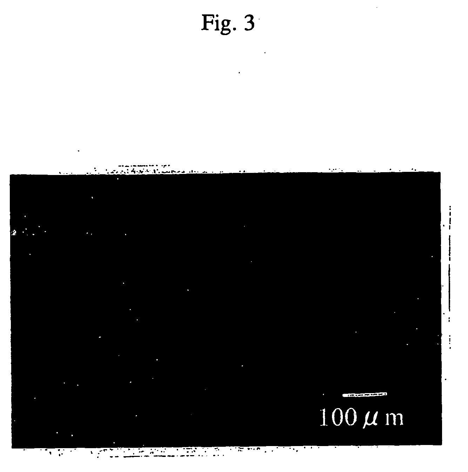

Plural organic molecules were fixed on the same substrate by repeating the same method as in Example 1. Photocurable resins containing, as an organic molecule, coumarin, zinc tetraphenylporphyrin (ZnTPP) and dicyanoanthracene, respectively were prepared. First of all, zinc tetraphenylporphyrin was fixed on a polyethyl methacrylate (PEMA) substrate using the photocurable resin containing zinc tetraphenylporphyrin, and the photocurable resin containing coumarin was then coated on the substrate, thereby fixing coumarin thereon in the same manner. In addition, the photocurable resin containing dicyanoanthracene was coated, thereby fixing dicyanoanthracene thereon in the same manner. The results obtained by fluorescent microscopic observation of the thus obtained substrate are shown in Fig. 3. The results reveal that it is possible to fix plural organic molecules on the same substrate.

### <Example 3>

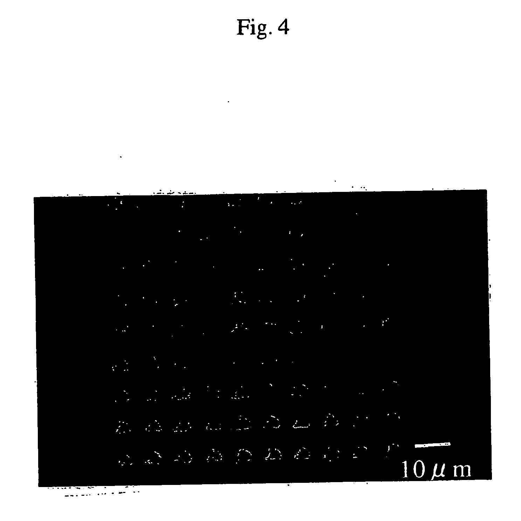

According to Method (B) of Fig. 1, visible laser light was irradiated on an ultraviolet light curable resin containing coumarin as an organic molecule, thereby curing only a desired portion, and thereafter, an uncured portion was removed by ethanol. Fig. 4 is a fluorescent microscopic photograph showing the prepared dot pattern. Dot size and interval were 1 µm and 10 µm, respectively. The ultraviolet light curable resin which is in general non-curable by visible light could be cured by visible light (light of a wavelength region which coumarin absorbs). In other molecules, it was confirmed that such a dot pattern can be prepared in the same manner and that the wavelength region of light at which curing is possible varies depending upon the organic molecule to be contained.

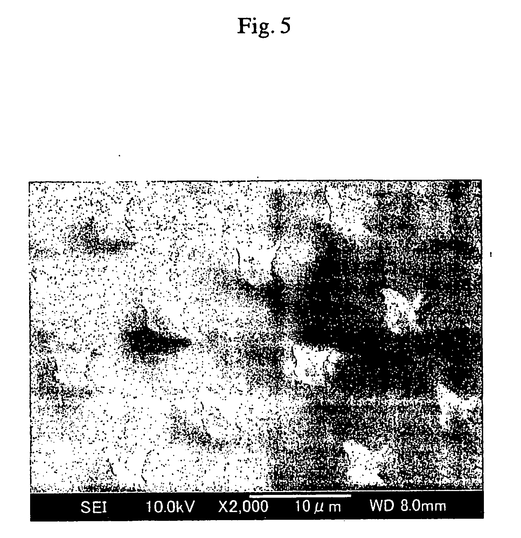

Fig. 5 shows the results of scanning electron microscopic observation of the foregoing dot pattern, and it was confirmed that the respective dots have a conical shape. This is a shape reflecting the beam shape. By changing it, dots having various shapes including a quadrangular pyramid and a triangular pyramid can be prepared.

### <Example 4>

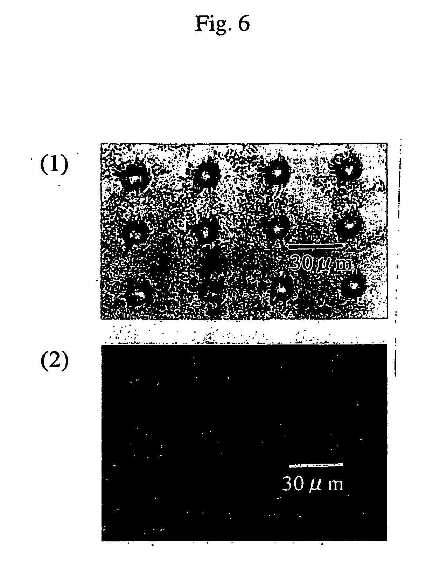

Ultraviolet laser light was irradiated on an ultraviolet light curable resin, thereby curing only a desired portion, and thereafter, an uncured portion was removed by ethanol. Fig. 6(1) is an optical photograph of the prepared dot pattern. Thereafter, the dot pattern was immersed in a solution having coumarin as an organic molecule dissolved therein, thereby penetrating and fixing coumarin. Fig. 6(2) is a fluorescent microscopic photograph of the dot pattern after the penetration of coumarin. It was confirmed that by immersing in a solution according to Method (C) of Fig. 1, coumarin was penetrated and fixed in the dots as prepared in advance.

### Industrial Applicability

In the light of the above, according to the invention of this application, an organic molecule having various functionalities can be fixed on a substrate simply and easily and in an arbitrary configuration or arrangement; excellent optical, electric or magnetic characteristics can be expected; and for example, optically excellent photonic crystals can be easily prepared by arranging dots having a specific refractive index in specific pitches. Also, it is possible to dispose plural kinds of organic molecules within the same fine region or to dispose them within different fine regions in close vicinity to each other. In addition, a wavelength region where a photocurable resin is curable can be easily measured by containing an organic molecule capable of absorbing specific light.

## Claims

1. A method of fixing an organic molecule on a micro/nano scale, **characterized by** irradiating a photocurable resin containing an organic molecule which does not react with the photocurable resin on a substrate with with light, thereby curing the photocurable resin in a given pattern and removing an uncured portion, thereby fixing the organic molecule in the given pattern on the substrate wherein said organic molecule Is selected from the group consisting of coumarin 6. coumarin 545, Zinc tetraphenylporphyrin (ZnTPP), anthracene, dicyanoanthracene, Nile Red, Fluoresceine and pyrene.

2. The method of fixing an organic molecule on a micro/nano scale according to claim 1, which is **characterized in that** condensed light is irradiated in a given pattern, thereby curing the photocurable resin in the given pattern.

3. The method of fixing an organic molecule on a micro/nano scale according to claim 2, which is **characterized in that** laser light is irradiated, thereby curing the photocurable resin in the given pattern.

4. The method of fixing an organic molecule on a micro/nano scale according to claim 1, which is **characterized in that** light is irradiated using a mask pattern, thereby curing the photocurable resin in the given pattern.

5. The method of fixing an organic molecule on a micro/nano scale according to any one of claims 1 to 4, which is **characterized in that** an organic molecule capable of absorbing light having a specific wavelength is contained and that light having a wavelength which the contained organic molecule absorbs is irradiated, thereby curing the photocurable resin.

6. A method of fixing an organic molecule on a micro/nano scale, which is **characterized by** curing a photocurable resin in a given pattern on a substrate by irradiation with light and subsequently bringing it into contact with a solution containing an organic molecule, which does not react with the photocurable resin, thereby penetrating the organic molecule into the photocurable resin, wherein said organic molecule is selected from the group consisting of coumarin 6, coumarin 545, ZnTPP, anthracene, dicyanoanthracene, Nile Red, Fluoresceine and pyrene.

7. The method of fixing an organic molecule on a micro/nano scale according to claim 6, which is **characterized in that** the organic molecule is penetrated by immersing in the solution of an organic molecule.

8. The method of fixing an organic molecule on a micro/nano scale according to claim 6 or 7, which is **characterized in that** condensed light is irradiated in a given pattern, thereby curing the photocurable resin in the given pattern.

9. The method of fixing an organic molecule on a micro/nano scale according to claim 8, which is **characterized in that** laser light is irradiated, thereby curing the photocurable resin in the given pattern.

10. The method of fixing an organic molecule on a micro/nano scale according to claim 6 or 7, which is **characterized in that** light is irradiated using a mask pattern, thereby curing the photocurable resin in the given pattern.

11. The method of fixing an organic molecule on a micro/nano scale according to any one of claims 1 to 10, which is **characterized In that** the cured shape of the photocurable resin is controlled by the beam shape of condensed light.

12. A method of fixing an organic molecule on a micro/nano scale, which is **characterized by** repeating a method according to any one according to claims 1 to 11 or combining them, thereby fixing each of plural kinds of organic molecules in an individual cured part of the photocurable resin.

13. The method of fixing an organic molecule on a micro/nano scale according to any one of claims 1 to 12, which is **characterized in that** the organic molecule is a molecule having at least one functionality of photo, magnetic and electronic functions.

14. A micro/nano article, which is **characterized by** being prepared by a method according to any one of claims 1 to 13.

## Patentansprüche

1. Verfahren zum Befestigen eines organischen Moleküls im Mikro-/Nanomaßstab, **gekennzeichnet durch** Bestrahlen eines photohärtbaren Harzes, das ein organisches Molekül enthält, welches nicht mit dem photohärtbaren Harz reagiert, auf ein Substrat mit Licht, wodurch das photohärtbare Harz in einem vorgegebenen Muster gehärtet wird und ein nicht gehärteter Abschnitt entfernt wird, wodurch das organische Molekül in dem vorgegebenen Muster auf dem Substrat befestigt wird, wobei das genannte organische Molekül aus der Gruppe ausgewählt wird, die aus Coumarin 6, Coumarin 545, Zinktetraphenylporphyrin (ZnTPP), Anthracen, Dicyanoanthracen, Nilrot, Fluorescein und Pyren besteht.

2. Verfahren zum Befestigen eines organischen Moleküls im Mikro-/Nanomaßstab gemäß Anspruch 1, das **dadurch gekennzeichnet ist, dass** kondensiertes Licht in einem vorgegebenen Muster gestrahlt wird, wodurch das photohärtbare Harz in dem vorgegebenen Muster gehärtet wird.

3. Verfahren zum Befestigen eines organischen Moleküls im Mikro-/Nanomaßstab gemäß Anspruch 2, das **dadurch gekennzeichnet ist, dass** Laserlicht gestrahlt wird, wodurch das photohärtbare Harz in dem vorgegebenen Muster gehärtet wird.

4. Verfahren zum Befestigen eines organischen Moleküls im Mikro-/Nanomaßstab gemäß Anspruch 1, das **dadurch gekennzeichnet ist, dass** Licht unter Verwendung eines Schablonenmusters gestrahlt wird, wodurch das photohärtbare Harz in dem vorgegebenen Muster gehärtet wird.

5. Verfahren zum Befestigen eines organischen Moleküls im Mikro-/Nanomaßstab nach einem der Ansprüche 1 bis 4, das **dadurch gekennzeichnet ist, dass** ein organisches Molekül, welches zur Absorption von Licht einer bestimmten Wellenlänge befähigt ist, enthalten ist und das Licht mit einer Wellenlänge, die das enthaltene organische Molekül absorbiert, gestrahlt wird, wodurch das photohärtbare Harz gehärtet wird.

6. Verfahren zum Befestigen eines organischen Moleküls im Mikro-/Nanomaßstab, das **dadurch gekennzeichnet ist, dass** ein photohärtbares Harz in einem vorgegebenen Muster auf einem Substrat durch Bestrahlen mit Licht und nachfolgendem In-Kontakt-bringen davon mit einer Lösung, die ein organisches Molekül enthält, welches nicht mit dem photohärtbaren Harz reagiert, wodurch das organische Molekül in das photohärtbare Harz penetriert, gehärtet wird, wobei das genannte organische Molekül aus der Gruppe ausgewählt wird, die aus Coumarin 6, Coumarin 545, ZnTPP, Anthracen, Dicyanoanthracen, Nilrot, Fluorescein und Pyren besteht.

7. Verfahren zum Befestigen eines organischen Moleküls im Mikro-/Nanomaßstab gemäß Anspruch 6, das **dadurch gekennzeichnet ist, dass** das organische Molekül durch Eintauchen in die Lösung eines organischen Moleküls penetriert wird.

8. Verfahren zum Befestigen eines organischen Moleküls im Mikro-/Nanomaßstab gemäß Anspruch 6 oder 7, das **dadurch gekennzeichnet ist, dass** kondensiertes Licht in einem vorgegebenen Muster gestrahlt wird, wodurch das photohärtbare Harz in dem vorgegebenen Muster gehärtet wird.

9. Verfahren zum Befestigen eines organischen Moleküls im Mikro-/Nanomaßstab gemäß Anspruch 8, das **dadurch gekennzeichnet ist, dass** Laserlicht gestrahlt wird, wodurch das photohärtbare Harz in dem vorgegebenen Muster gehärtet wird.

10. Verfahren zum Befestigen eines organischen Moleküls im Mikro-/Nanomaßstab gemäß Anspruch 6 oder 7, das **dadurch gekennzeichnet ist, dass** Licht unter Verwendung eines Schablonenmusters gestrahlt wird, wodurch das photohärtbare Harz in dem vorgegebenen Muster gehärtet wird.

11. Verfahren zum Befestigen eines organischen Moleküls im Mikro-/Nanomaßstab gemäß einem der Ansprüche 1 bis 10, das **dadurch gekennzeichnet ist, dass** die gehärtete Form des photohärtbaren Harzes durch die Strahlform von kondensierten Licht gesteuert wird.

12. Verfahren zum Befestigen eines organischen Moleküls im Mikro-/Nanomaßstab, das durch Widerholen eines Verfahrens gemäß einem der Ansprüche 1 bis 11 oder der Kombination davon gekennzeichnet ist, wodurch jedes von zahlreichen Arten von organischen Molekülen in einem individuell gehärteten Teil des photohärtbaren Harzes fixiert wird.

13. Verfahren zum Befestigen eines organischen Moleküls im Mikro-/Nanomaßstab gemäß einem der Ansprüche 1 bis 12, das **dadurch gekennzeichnet ist, dass** das organische Molekül ein Molekül mit wenigstens einer Funktionalität von Photo-, magnetischen und elektronischen Funktionen ist.

14. Mikro-/Nanogegenstand, der **dadurch gekennzeichnet ist, dass** er durch ein Verfahren gemäß einem der Ansprüche 1 bis 13 hergestellt wird.

## Revendications

1. Procédé de fixation d'une molécule organique à l'échelle micro/nanométrique, **caractérisé par** l'irradiation d'une résine photodurcissable contenant une molécule organique qui ne réagit pas avec la résine photodurcissable sur un substrat avec de la lumière, durcissant de la sorte la résine photodurcissable selon un motif donné et éliminant une portion non durcie, en fixant ainsi la molécule organique selon le motif donné sur le substrat, dans lequel ladite molécule organique est sélectionnée dans le groupe constitué de la coumarine 6, de la coumarine 545, de la tétraphénylporphyrine de zinc (ZnTPP), de l'anthracène, du dicyanoanthracène, du rouge du Nil, de la fluorescéine et du pyrène.

2. Procédé de fixation d'une molécule organique à l'échelle micro/nanométrique selon la revendication 1, qui est **caractérisé en ce que** de la lumière condensée est irradiée selon un motif donné, durcissant de la sorte la résine photodurcissable selon le motif donné.

3. Procédé de fixation d'une molécule organique à l'échelle micro/nanométrique selon la revendication 2, qui est **caractérisé en ce que** de la lumière laser est irradiée, durcissant de la sorte la résine photodurcissable selon le motif donné.

4. Procédé de fixation d'une molécule organique à l'échelle micro/nanométrique selon la revendication 1, qui est **caractérisé en ce que** de la lumière est irradiée en utilisant un motif de masque, durcissant de la sorte la résine photodurcissable selon le motif donné.

5. Procédé de fixation d'une molécule organique à l'échelle micro/nanométrique selon l'une quelconque des revendications 1 à 4, qui est **caractérisé en ce qu'**une molécule organique capable d'absorber de la lumière ayant une longueur d'onde spécifique est contenue et **en ce que** de la lumière ayant une longueur d'onde que la molécule organique contenue absorbe est irradiée, durcissant de la sorte la résine photodurcissable.

6. Procédé de fixation d'une molécule organique à l'échelle micro/nanométrique, qui est **caractérisé par** le durcissement d'une résine photodurcissable selon un motif donné sur un substrat par irradiation avec de la lumière et par sa mise en contact, ensuite, avec une solution contenant une molécule organique qui ne réagit pas avec la résine photodurcissable, faisant pénétrer de la sorte la molécule organique dans la résine photodurcissable, dans lequel ladite molécule organique est sélectionnée dans le groupe constitué de la coumarine 6, de la coumarine 545, de la ZnTPP, de l'anthracène, du dicyanoanthracène, du rouge du Nil, de la fluorescéine et du pyrène.

7. Procédé de fixation d'une molécule organique à l'échelle micro/nanométrique selon la revendication 6, qui est **caractérisé en ce que** la molécule organique est pénétrée par immersion dans la solution d'une molécule organique.

8. Procédé de fixation d'une molécule organique à l'échelle micro/nanométrique selon la revendication 6 ou la revendication 7, qui est **caractérisé en ce que** de la lumière condensée est irradiée selon un motif donné, durcissant de la sorte la résine photodurcissable selon le motif donné.

9. Procédé de fixation d'une molécule organique à l'échelle micro/nanométrique selon la revendication 8, qui est **caractérisé en ce que** de la lumière laser est irradiée, durcissant de la sorte la résine photodurcissable selon le motif donné.

10. Procédé de fixation d'une molécule organique à l'échelle micro/nanométrique selon la revendication 6 ou la revendication 7, qui est **caractérisé en ce que** de la lumière est irradiée en utilisant un motif de masque, durcissant de la sorte la résine photodurcissable selon le motif donné.

11. Procédé de fixation d'une molécule organique à l'échelle micro/nanométrique selon l'une quelconque des revendications 1 à 10, qui est **caractérisé en ce que** la forme durcie de la résine photodurcissable est réglée par la forme du faisceau de lumière condensée.

12. Procédé de fixation d'une molécule organique à l'échelle micro/nanométrique, qui est **caractérisé par** la répétition d'un procédé selon l'une quelconque des revendications 1 à 11 ou leur combinaison, fixant de la sorte chacun des multiples types de molécules organiques dans une partie individuelle durcie de la résine photodurcissable.

13. Procédé de fixation d'une molécule organique à l'échelle micro/nanométrique selon l'une quelconque des revendications 1 à 12, qui est **caractérisé en ce que** la molécule organique est une molécule ayant au moins une fonctionnalité de fonctions photo, magnétique et électronique.

14. Article micro/nanométrique qui est **caractérisé par** sa préparation par un procédé selon l'une quelconque des revendications 1 à 13.
